# EUROPÄISCHE PATENTSCHRIFT

(11) **EP 1 875 307 B1**
(45) Veröffentlichungstag und Bekanntmachung des Hinweises auf die Patenterteilung: **05.08.2009**
(21) Anmeldenummer: 06706655.5
(22) Anmeldetag: 04.02.2006
(51) Int. Cl.: G03F 1/00, G03F 7/20

(54) **VERFAHREN ZUR MASKENINSPEKTION IM RAHMEN DES MASKENDESIGNS UND DER MASKENHERSTELLUNG**
METHOD FOR MASK INSPECTION FOR MASK DESIGN AND MASK PRODUCTION
PROCEDE D'INSPECTION DE MASQUES DANS LE CADRE DE LA CONCEPTION ET DE LA PRODUCTION DE MASQUES

(30) Priorität: 25.02.2005 DE 102005009536
(43) Veröffentlichungstag der Anmeldung: 09.01.2008
(73) Patentinhaber: Carl Zeiss SMS GmbH, 07745 Jena (DE); Synopsys GmbH, 85609 Aschheim-Dornach (DE)
(72) Erfinder: HARNISCH, Wolfgang, 07778 Lehesten (DE); ZIBOLD, Axel, 07749 Jena (DE); BÖHM, Klaus, 07629 Schleifreisen (DE); KALUS, Christian, 80797 München (DE); SCHMÖLLER, Thomas, 81673 München (DE)
(74) Vertreter: Niestroy, Manfred
(86) Internationale Anmeldenummer: PCT/EP2006/001000
(87) Internationale Veröffentlichungsnummer: WO 2006/089630

(56) Entgegenhaltungen:
- EP-A- 1 093 017
- WO-A-20/04008244
- US-A- 5 795 688
- US-A1- 2004 243 320
- ZIBOLD AXEL ET AL: "Using the aerial image measurement technique to speed up mask development for 193-nm immersion and polarization lithography" PROCEEDINGS OF THE SPIE - THE INTERNATIONAL SOCIETY FOR OPTICAL ENGINEERING SPIE-INT. SOC. OPT. ENG USA, Bd. 5645, Januar 2005 (2005-01), Seiten 223-232, XP002375854 ISSN: 0277-786X

## Beschreibung

### Gebiet der Erfindung

Die vorliegende Erfindung betrifft ein Verfahren zur Maskeninspektion, welches im Rahmen des Maskendesigns der Maskenherstellung eingesetzt werden kann, um relevante Schwachstellen bereits frühzeitig erkennen und korrigieren zu können.

### Stand der Technik

Immer kleiner werdende Objektstrukturgrößen auf dem Wafer stellen immer größere Anforderungen an das Maskendesign und die Maskenherstellung. Da das von der Maske erzeugte Abbild verkleinert auf den Wafer abgebildet wird, wirken sich Schwachstellen auf der Maske (sogenannte Hotspots) besonders aus. Außerdem liegen die gegenwärtig benutzten Strukturgrößen der kritischen Masken im Bereich der Auflösungsgrenze der Waferbelichtungssysteme, so dass die sogenannten Hotspots immer dominanter werden. Die Analyse von Defekten im Maskenherstellungsprozess und insbesondere im Prozess des Maskendesigns wird durch die kleiner werdenden Strukturen immer wichtiger.

Zu Analyse von Maskendefekten hinsichtlich Printability ist seit 10 Jahren das AIMS™ (Aerial Imaging Measurement System) der Carl Zeiss SMS GmbH im Markt etabliert. Dabei wird ein kleiner Bereich der Maske (Defektort mit Umgebung) mit den gleichen Beleuchtungs- und Abbildungsbedingungen (Wellenlänge, NA, Beleuchtungstyp, Kohärenzgrad des Lichtes (Sigma)) wie im lithographischen Scanner beleuchtet und abgebildet. Im Gegensatz zum Scanner wird jedoch das von der Maske erzeugte Luftbild auf eine CCD-Kamera vergrößert. Die Kamera sieht das gleiche latente Bild wie der Resist auf dem Wafer. Somit kann ohne aufwändige Testprints durch Waferbelichtungsgeräte das Luftbild analysiert und Rückschlüsse auf die Printability der Maske gezogen werden. Durch Aufnahme einer Fokusreihe bekommt man zusätzliche Informationen zur Analyse des lithographischen Prozessfensters.

Nach dem bekannten Stand der Technik erfolgt nach dem Maskendesign, das Maskenlayout und das Fertigen der Lithographiemaske. Die Lithographiemaske wird dann von einer Inspektionseinheit auf Fehler untersucht, die dann von einer Reparatureinheit korrigiert werden, wobei in der Regel nicht alle Fehler erkannt werden können. Die von der Inspektionseinheit nicht erkannten Fehler werden dann erst bei der Belichtung der Wafer erkannt und führen zu einer hohen Fehlerquote in der Produktion. Neben der daraus resultierenden Produktionsverzögerung führen die Maskenreparatur oder der Kauf einer neuen Maske zu erheblichen Extrakosten die sich durch Kosten infolge der Produktionsverzögerung noch erheblich erhöhen können.

In der Offenlegunsschrift WO 00/60415 A1 wird ein Verfahren zur Korrektur von Abbildungsfehlern beschrieben, bei dem durch Änderung eines elektronischen Maskenentwurfes nach Belichten dieses Maskenentwurfes durch einen Maskenschreiber auf der Maske Strukturen abgebildet werden, die dem ursprünglichen Maskenentwurf bzw. der Soll-Maske möglichst nahe kommen. Die zu berücksichtigenden Prozessbedingungen werden dabei in Form von Tabellen zusammengefasst, die insbesondere die von den Prozessbedingungen abhängigen Parameter in Form von Korrekturwerten beinhalten. Beispielsweise sind in den Tabellen ortsabhängig unterschiedliche Korrekturwerte zur Kompensation der geräteabhängigen Aberration des Maskenschreibers enthalten. Dabei setzt die Lösung für sämtliche Korrekturwerte physikalisch begründete Modelle der entsprechenden Abbildungsfehler voraus. Mit dem vorgeschlagenen Verfahren ist es im Gegensatz zu bekannten Verfahren zwar möglich, Maskenstrukturen zur Erzeugung hochintegrierter Schaltkreise effektiv zu korrigieren, allerdings ist der rechnerische Aufwand erheblich. Ein weiterer Nachteil dieses Verfahrens liegt in der Vielzahl der in Form von Korrekturwerten zu berücksichtigenden Parameter. Dabei sind neben Beugungs- und Brechungseffekten auch Wechselwirkungseffekte und gerätebedingte Aberrationseffekte zu berücksichtigen.

In einem Artikel von A. Zibold et al., erschienen in "Advanced Microlithography Technologies", Proc. of SPIE Vol. 5645 (2005), S. 223-232, wird ein Verfahren zur Maskeninspektion beschrieben, welches im Rahmen der Entwicklung und der Herstellung von Masken eingesetzt werden kann. Dabei werden Luftbilder sowohl simuliert als auch anhand von Testmasken gemessen und anschließend verglichen, um auf diese Weise einfacher kritische Stellen auf der Maske zu identifizieren. Auf diese Weise kann der Herstellungsprozeß beschleunigt werden.

Mit den im Stand der Technik bekannten Verfahren kann nicht sicher gestellt werden, dass von der verwendeten Inspektionsmaschine alle Fehler erkannt werden, so dass es vorkommen kann, dass Fehler auf der Maske erst bei der Produktion in der Waferfab erkannt werden. Dies erzeugt Mehrkosten für Maskenrepair oder den Kauf einer neuen Maske und führt außerdem zu Produktionsverzögerung und weiteren Folgekosten.

### Beschreibung der Erfindung

Der vorliegenden Erfindung liegt die Aufgabe zugrunde, die im Stand der Technik bekannten Lösungen dahingehend zu verbessern, dass Fehler bereits im Maskenlayout und Maskendesign erkannt und beseitigt werden können, so dass die erzeugten Masken eine geringere Fehlerquote aufweisen und Kosten minimiert werden.

Erfindungsgemäß wird die Aufgabe durch die Merkmale der unabhängigen Ansprüche gelöst. Bevorzugte Weiterbildungen und Ausgestaltungen sind Gegenstand der abhängigen Ansprüche.

Bei dem Verfahren zur Maskeninspektion im Rahmen des Maskendesigns und der Maskenherstellung wird von dem entworfenen und in ein Maskenlayout überführten Maskendesign eine "aerial image"-Simulation durchgeführt, um daraus eine Liste der kritischen Stellen (Hotspots) zu ermitteln. Anhand dieser Hotspots wird die Maske/Testmaske mit Hilfe eines AIMS-Tools analysiert, indem reale "aerial images" erzeugt und mit den simulierten "aerial images" verglichen werden. Dabei werden die beiden "aerial images" strukturgenau miteinander korreliert und an ein und demselben Ort auf die Linienbreite oder Größe des sogenannten Prozessfenster ausgewertet. Entweder, die ermittelten Unterschiede der Ergebnisse oder das reale "aerial image" Ergebnis selbst werden zur Verbesserung des Maskendesigns verwendet. Beim Vergleich der realen "aerial images" mit den simulierten wird festgestellt, ob in den realen "aerial images" enthaltene Verzeichnungen durch eine Verzeichnung der Maske selbst, oder durch eine nicht ausreichende optische Korrektur verursacht sind.

Die ermittelten Unterschiede der "aerial images" Ergebnisse dienen der Verbesserung des Designs, wobei die Qualität der Maske durch mehrmaliges Durchlaufen der genannten Verfahrensschritte verbessert werden kann.

Durch die Verwendung des AIMS-Tools direkt im Maskenherstellungsprozess ist eine wesentliche Beschleunigung der Maskenherstellung, bei Verringerung der Fehlerquote und Kosteneinsparung möglich. Bei den in Zukunft durch die zunehmende Komplexität ständig teuerer werdenden Masken können frühzeitig relevante Schwachstellen im Masken-Herstellungsprozess erkannt werden und zwar bevor Fehler in der Herstellung von elektronischen Bauelementen vorkommen.

### Kurze Beschreibung der Zeichnung

Die erfindungsgemäße Lösung wird nachfolgend anhand eines Ausführungsbeispieles beschrieben. Dazu zeigt:

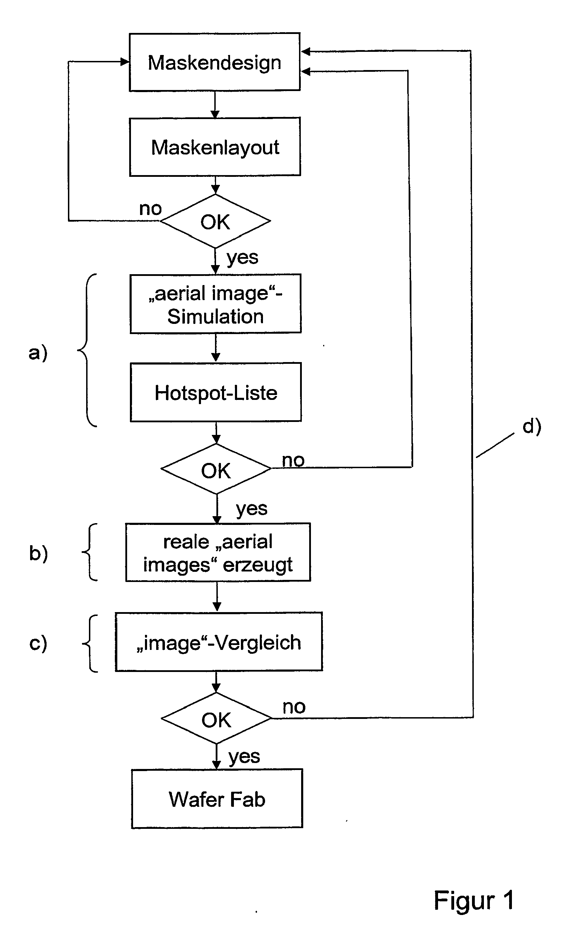

Fig. 1 ein Ablaufschema der einzelnen Verfahrensschritte

### Ausführliche Beschreibung der Zeichnung

Bei dem Verfahren zur Maskeninspektion im Rahmen des Maskendesigns und der Maskenherstellung wird von dem entworfenen und in ein Maskenlayout überführten Maskendesign eine "aerial image"-Simulation, vorzugsweise eine vollflächige "aerial image"-Simulation durchgeführt, um daraus eine Liste der kritischen Stellen (Hotspots) zu ermitteln. Anhand dieser Hotspots wird die Maske/Testmaske mit Hilfe eines AIMS-Tools analysiert, indem reale "aerial images" erzeugt und mit den simulierten "aerial images" verglichen werden. Die ermittelten Unterschiede der "aerial images" werden zur Verbesserung des Maskendesigns verwendet.

Bei der Überführung des Maskendesign in ein entsprechendes Maskenlayout können so genannten RET-Technologien (Resolution Enhancement Techniques), wie beispielsweise die OPC-Technik (Optical Proximity Correction) angewendet werden. In der OPC-Technik werden die ursprünglichen Strukturen des Design-Datensatzes so verändert, dass die "Strukturverschmierung" durch die Beugung des Lichts weitgehend kompensiert wird. Eine quadratische Struktur in der Maske würde durch die Beugung des Lichts an der Maske und Abbildungsfehler des Linsensystems im Resist als Kreis abgebildet werden. Durch die OPC-Technik werden die Ecken des Quadrats in der Maske durch zusätzliche Strukturen "ausgebeult", was die Verrundung des Resistbildes minimiert. Mit der OPC-Technik werden die Strukturen auf der Maske so verändert, dass erst durch die Beugungseffekte die gewünschte Struktur auf dem Chip entsteht. Statt einfacher Polygone müssen komplexe geometrische Strukturen erzeugt werden, die die Datenmengen stark ansteigen lassen. Fehler in der Abbildung werden durch vorausberechnete "Gegenfehler" in der Maske kompensiert.

In Fig.1 wird dazu ein Ablaufschema der einzelnen Verfahrensschritte dargestellt. Ein entworfenes Maskendesign wird hierbei in das entsprechende Maskenlayout überführt. Bereits im Stadium der Umsetzung in das Maskenlayout können kritische Stellen zu Änderungen im Maskendesign führen. Gemäß dem Verfahrensschritt a) wird vom fertigen Maskenlayout eine "aerial image"-Simulation durchgeführt, um daraus eine Liste der kritischen Stellen (Hotspot-Liste) zu ermitteln.

Die Liste der kritischen Stellen (Hotspots) wird durch Analyse der simulierten "aerial images" ermittelt, indem beispielsweise die Beleuchtungsbedingungen, die Bedingungen der Maskenherstellung und/oder die Stepperbedingungen variiert werden. Eine Ermittlung und Variation des Prozessfensters ist durch Änderung der Beleuchtungsdosis bzw. Defokussierung möglich. Zu den veränderbaren Bedingungen bei der Maskenherstellung sind beispielsweise Ätztiefe, Mask Bias und Mask Corner Rounding. Stepperbedingungen sind z. B. numerische Apertur, Beleuchtungstypen, Koheränzgrad und Polarisation.

Die Liste der kritischen Stellen wird durch iterative Verbesserungen im Design mit anschließender erneute vollflächige "aerial Image"-Simulation minimiert. Die Analyse erfolgt hierbei durch vollflächigen Verifikation des Maskenlayouts, durch Erzeugung vollflächige "aerial image" Simulationen der Maske, wobei das Strukturbild das später auf dem elektronischen Bauelement zum Einsatz kommt erzeugt wird. Basierend auf einer Analyse der simulierten Aerial images in Relation zu dem gewünschten Design, oder nach Vorauswahl durch einen Ingenieur in einem Übersichtsbild der Simulation wird eine Liste von Stellen, so genannte Hotspots, auf der Maske erzeugt, deren Luftbild oder kritische Linienbreite Fehler in der Maskenherstellung erwarten lässt.

Die Minimierung der Hotspot-Liste erfolgt beispielsweise durch Optimierung der Lithographiebedingungen (wie: NA, Kohärenz und Blende). Bei Anwendung der OPC-Technik ist die Minimierung der Hotspot-Liste auch durch globale und/oder lokale Korrektur der OPC-Strukturen möglich. So können beispielsweise alle im Maskendesign enthaltenen Ecken gleicher Größe gleichzeitig mit den gleichen Veränderung (global) korrigiert werden.

Die Hotspot-Liste kann aber auch durch Analyse des Layouts hinsichtlich dichtgepackte Stellen und kleinster Strukturen oder auch durch "die-to-die"-Vergleich sich wiederholender Stellen ermittelt werden.

Alle kritischen Stellen werden auf Verbesserungsfähigkeit des Designs geprüft und die Hotspot-Liste durch iterative Verbesserung im Design mit anschließender erneute vollflächige "aerial image"-Simulation minimiert.

Zur iterativen Verbesserung des Designs wird die Abbildung im Scanner durch kohärentes oder teilkohärentes Licht örtlich hochkorreliert, d. h. eine Änderung an einer lokalen Stelle hat Auswirkungen auf andere lokale Stellen. Führt man eine globale Änderung durch, so wirkt sich die Änderung auf das gesamte Layout aus. Das bedeutet streng genommen, dass man das Layout global optimieren muss. Aus praktischen Gründen beschränkt man sich auf wenige Punkte und wiederholt das Verfahren so lange bis Konvergenz, d. h. bis ein stabiler Zustand erreicht ist. Es muss damit gerechnet werden, dass sich lokale Punkte außerhalb der optimierten Fläche durch eine iterative Änderung verschlechtern können.

Liegt eine minimierte Hotspot-Liste vor, so wird ausgehend vom Maskenlayout eine Maske als Testmaske oder auch als Fullfieldmaske hergestellt. Diese Maske wird, basierend auf der Hotspot-Liste und unter Stepper/Scanner-Bedingungen in Kombination mit verschiedenen Mode-Typen, mit Hilfe eines AIMS-Tools analysiert, indem reale "aerial images" erzeugt werden. Dies entspricht dem Verfahrensschritt b) gemäß Figur 1. Im Anschluss werden die realen und simulierten "aerial images" im Verfahrensschritt c) verglichen und die Unterschiede ermittelt.

Der Vergleich der simulierten und realen Luftbilder kann jedoch erst nach der Eichung des Systems an Teststrukturen erfolgten. Als Teststrukturen kommen dabei eindimensionale oder zweidimensionale Gitter zum Einsatz, deren Struktur zumindest parallel zu einer der beiden Hauptachsen liegt. Neben diesen Gitterstrukturen sind aber auch quadratische Strukturen, wie Lochraster verwendbar, deren quadratische Löcher rund abgebildet werden.

Der Vergleich der beiden Bilder erfolgt unter Verwendung eines einfachen Schwellwertmodells. Verwendet man als Teststruktur ein gleichmäßiges, eindimensionales Gitter und bestimmt in der durch Abbildung erhaltenen Intensitätsverteilung mit sinusähnlichem Verlauf einen Schwellwert, so stellen die Schnittpunkte eines Peaks an diesem Schwellwert die auflösbare Strukturbreite dar. Je höher der Schwellwert, desto geringer wird die Strukturbreite. Bei Verwendung einer zweidimensionalen Teststruktur erhält man eine vollflächige Intensitätsverteilung mit vermuteten Konturlinien des Maskenlayouts in beiden Bildern. Ist der Unterschied der Strukturbreiten in den beiden Bildern größer als eine vorgegebene Toleranz, so wird die Stelle (Fläche) als fehlerhaft markiert.

Diese Unterschiede, die sich in verschiedenen Linienbreiten, Flächengrößen oder Prozessfenstergrössen äußern, werden zur Verbesserung des Designs verwendet.

Im Gegensatz zur Luftbildsimulation enthält das AIMS-Bild die reale Verzeichnung der Maske durch den nicht-idealen Maskenschreibvorgang. Diese realen Verzeichnungen können dabei durch Verzeichnungen der Maske selbst (Ebeam-Proximityeffekt) und/oder durch eine nicht ausreichende optische Korrektur verursacht sein. Da die Effekte zum Teil gegenläufig und somit getrennt zu korrigieren sind, muss festgestellt werden, welcher dieser Effekte für die realen Verzeichnungen verantwortlich ist.

Dazu werden an bestimmten (kritischen) Messstellen Linienbreiten und/oder Kantenverschiebungen für das Maskenschreiben simuliert, wobei die Maskentechnologie bekannt sein muss. Anschließend wird an denselben Stellen die optische Belichtung simuliert, wobei die Lithographiebedingungen bekannt sein müssen.

Für beide Schritte werden die Abweichungen in Abhängigkeit vom Messort dokumentiert. Sie ergeben charakteristische Signaturen für die Maskenlithographie σₘ und für die optische Lithographie σₒ.

Anschließend werden die Signaturen mit der Signatur der beobachteten Messwerte σ_{b} verglichen indem man die Korrelationskoeffizienten ρ_{mb} gegenüber Maske und pob gegenüber Optik bestimmt.

Die Korrelationskoeffizienten geben ein Maß (in der Form einer mathematischen Wahrscheinlichkeit) für den Einfluss, den die Maskenbelichtung bzw. die optische Belichtung auf die tatsächliche Beobachtung hat. Dabei kann die Genauigkeit der Aussage erhöhen, indem man an unterschiedlichen Stellen im Layout misst, was in der Praxis sowieso getan wird. Jedes Wertepaar ergibt dann eine Zeile in einer Korrelationsmatrix. Aus der Korrelationsmatrix lassen sich die gesamten Korrelationskoeffizienten für Maske und Optik mit höherer Genauigkeit bestimmen.

Stellt sich dabei heraus, dass die realen Verzeichnungen aus der Maske selbst (Ebeam-Proximityeffekt) resultieren, so ist die Maske entsprechend zu korrigieren. Resultieren die realen Verzeichnungen im Gegensatz dazu aus optisch bedingten Effekten (Optical Proximity Correction), so ist die Hotspot-Liste wie oben beschrieben zu minimieren.

Entsprechen diese Unterschiede vorgegebenen Grenzen, so ist die Qualität des Maskenlayouts ausreichend und die Maske kann in die Wafer Fab weitergeleitet werden. Durch mehrmaliges Durchlaufen der einzelnen Verfahrensschritte verbessert sich die Qualität des Maskenlayouts entsprechend.

Mit der erfindungsgemäßen Anordnung wird ein Verfahren zur Maskeninspektion im Rahmen des Maskendesigns und der Maskenherstellung zur Verfügung gestellt, mit dem ein deutlicher Qualitätssprung im Maskendesign erfolgt. Durch die Möglichkeit einer frühzeitigen Überprüfung der Einsetzbarkeit von Masken für die Massenproduktion kann die Maskenherstellung bei gleichzeitiger Senkung der Kosten wesentlich beschleunigt werden. Insbesondere für die immer teurer werdenden Masken ist eine frühzeitig Erkennung relevanter Schwachstellen im MaskenHerstellungsprozess von wachsender Bedeutung.

## Patentansprüche

1. Verfahren zur Maskeninspektion im Rahmen des Maskendesigns und/oder der Maskenherstellung, bei dem von dem entworfenen und in ein Maskenlayout überführten Maskendesign
a) eine "aerial image"-Simulation durchgeführt wird, um eine Liste der kritischen Stellen (Hotspots) zu ermitteln,
b) anhand dieser Hotspots die Maske und/oder Testmaske mit Hilfe eines AIMS-Tools analysiert wird, indem reale "aerial images" erzeugt werden,
c) die mit den simulierten "aerial images" verglichen werden und
d) die ermittelten Unterschiede der "aerial images" zur Verbesserung des Designs der Maske genutzt werden,
**dadurch gekennzeichnet, daß** festgestellt wird, ob in den realen "aerial images" enthaltene Verzeichnungen durch eine Verzeichnung der Maske selbst oder eine nicht ausreichende optische Korrektur verursacht worden sind.

2. Verfahren nach Anspruch 1, bei dem im Verfahrensschritt d) zur Ermittlung der Ursachen für die realen Unterschiede der "aerial images" Korrelationsmatrizen verwendet werden, deren Korrelationskoeffizienten ρ_{mb} durch Vergleich der charakteristischen Signaturen für die Maskenlithographie σₘ und für die optische Lithographie σₒ mit den beobachteten Messwerten σ_{b} ermittelt werden.

3. Verfahren nach Anspruch 1 oder 2, bei dem im Verfahrensschritt a) die "aerial image"-Simulation zur Ermittlung der Liste der kritischen Stellen (Hotspots) vorzugsweise eine vollflächige "aerial image"-Simulation ist.

4. Verfahren nach einem der Ansprüche 1 bis3, bei dem im Verfahrensschritt a) die Liste der kritischen Stellen durch iterative Verbesserungen im Design mit anschließende erneuter vollflächiger "aerial image"-Simulation minimiert wird.

5. Verfahren nach einem der Ansprüche 1 bis 4, bei dem im Verfahrensschritt a) die Liste der kritischen Stellen durch Analyse der simulierten "aerial images" durch Variation der Beleuchtungsbedingungen, der Bedingungen der Maskenherstellung und/oder der Stepperbedingungen, durch Analyse des Layout hinsichtlich dichtgepackter Stellen und kleinster Strukturen oder auch durch "die-to-die"-Vergleich sich wiederholender Stellen ermittelt werden.

6. Verfahren nach einem der Ansprüche 1 bis 5, bei dem die im Verfahrensschritt b) hergestellte Maske eine Testmaske oder auch eine Fullfieldmaske ist.

7. Verfahren nach einem der Ansprüche 1 bis 6, bei dem die Verfahrensschritte a) bis d) zur Verbesserung der Qualität der Maske mehrmals durchlaufen werden.

8. Verfahren nach einem der Ansprüche 1 bis 7, bei dem bei der Überführung des Maskendesigns in ein Maskenlayout so genannte RET-Technologien, wie beispielsweise die OPC-Technik zur Anwendung kommen.

## Claims

1. Method of mask inspection in the context of mask design and/or mask production, wherein from the mask design, which has been drafted and transferred to a mask layout
a) an "aerial image" simulation is carried out, to determine a list of the critical points (hotspots),
b) on the basis of these hotspots, the mask and/or test mask is analysed using an AIMS tool, real "aerial images" being generated,
c) which are compared with the simulated "aerial images", and
d) the determined differences of the "aerial images" are used to improve the design of the mask,
**characterized in that** it is established whether distortions which are contained in the real "aerial images" have been caused by a distortion in the mask itself or by an insufficient optical correction.

2. Method according to Claim 1, wherein in method step d), to determine the causes for the real differences of the "aerial images", correlation matrices are used, the coefficients of correlation ρ_{mb} of which are determined by comparison of the characteristic signatures for the mask lithography σₘ, and for the optical lithography σₒ, with the observed measured values σ_{b}.

3. Method according to Claim 1 or 2, wherein in method step a), the "aerial image" simulation to determine the list of the critical points (hotspots) is preferably an all-over "aerial image" simulation.

4. Method according to one of Claims 1 to 3, wherein in method step a), the list of critical points is minimised by iterative improvements in the design, followed by repeated all-over "aerial image" simulation.

5. Method according to one of Claims 1 to 4, wherein in method step a), the list of critical points is determined by analysing the simulated "aerial images" by varying the lighting conditions, conditions of mask production and/or stepper conditions, by analysing the layout with respect to densely packed points and very small structures, or by "die-to-die" comparison of repeated points.

6. Method according to one of Claims 1 to 5, wherein the mask produced in method step b) is a test mask or a full field mask.

7. Method according to one of Claims 1 to 6, wherein method steps a) to d) are run through multiple times, to improve the quality of the mask.

8. Method according to one of Claims 1 to 7, wherein to transfer the mask design into a mask layout, so-called RET technologies such as the OPC technique are used.

## Revendications

1. Procédé d'inspection de masques dans le cadre de la conception et/ou de la fabrication de masques, dans lequel, à partir de la conception transformée en dessin de masque
a) une simulation "d'image aérienne" est effectuée afin de déterminer une liste des points critiques ("hots pots")
b) le masque et/ou le masque de test est analysé au moyen de ces points critiques à l'aide d'un outil AIMS, par le fait que des "images aériennes" réelles sont générées,
c) qui sont comparées aux "images aériennes" simulées et
d) les différences relevées des "images aériennes" sont utilisées pour améliorer le dessin du masque,
**caractérisé en ce qu'**il est déterminé si des distorsions contenues dans les "image aériennes" réelles ont été causées par une distorsion du masque lui-même ou par une correction optique insuffisante.

2. Procédé selon la revendication 1, dans lequel, à l'étape d) du procédé, pour la détection des causes pour les différences réelles des "images aériennes", des matrices de corrélation sont utilisées, dont les coefficients de corrélation ρ_{mb} sont déterminés par comparaison des signatures caractéristiques, pour la lithographie de masque σₘ et pour la lithographie optique σₒ avec les valeurs de mesures observées.

3. Procédé selon la revendication 1 ou 2, dans lequel, à l'étape a) du procédé, la simulation "d'image aérienne" pour la détermination de la liste des points critiques ("hots pots") est de préférence une simulation "d'image aérienne" sur toute la surface.

4. Procédé selon l'une des revendications 1 à 3, dans lequel, à l'étape a) du procédé, la liste des points critiques est minimisée par des améliorations itératives dans le dessin avec une nouvelle simulation consécutive "d'image aérienne" sur toute la surface.

5. Procédé selon l'une des revendications 1 à 4, dans lequel la liste des points critiques est déterminée par l'analyse des "images aériennes" simulées, par variation des conditions d'éclairage, des conditions de fabrication du masque et/ou des conditions de déroulement pas à pas, par l'analyse du dessin de masque en ce qui concerne les points très compactés et de structures plus petites et aussi par une comparaison "matrice à matrice" des points qui se répètent.

6. Procédé selon l'une des revendications 1 à 5, dans lequel le masque réalisé à l'étape b) du procédé est un masque de test ou aussi un masque plein champ.

7. Procédé selon l'une des revendications 1 à 6 dans lequel les étapes a) à d) du procédé vont être accomplies plusieurs fois pour améliorer la qualité du masque.

8. Procédé selon l'une des revendications 1 à 7 dans lequel lors de la transformation du projet de masque en un dessin de masque, on utilise des technologies dites RET, comme par exemple la technique OPC.
